# EUROPEAN PATENT SPECIFICATION

(11) **EP 3 175 674 B1**
(45) Date of publication and mention of the grant of the patent: **03.07.2019**
(21) Application number: 14898565.8
(22) Date of filing: 28.07.2014
(51) Int. Cl.: H04B 1/38, H01L 25/065

(54) **CONCURRENT DUAL-BAND WLAN DEVICE USING MCM**
GLEICHZEITIGE DUALBAND-WLAN-VORRICHTUNG MIT MCM
DISPOSITIF DE WLAN BI-BANDE SIMULTANÉ UTILISANT UN MCM

(43) Date of publication of application: 07.06.2017
(73) Proprietor: Celeno Communications (Israel) Ltd., 43665 Ra'anana (IL)
(72) Inventor: SHAPIRA, Nir, 43590 Ra'anana (IL)
(74) Representative: Beck Greener LLP
(86) International application number: PCT/IB2014/063473
(87) International publication number: WO 2016/016684

(56) References cited:
- US-A1- 2011 038 282
- US-A1- 2012 250 666
- US-A1- 2012 250 666
- US-A1- 2014 131 854
- US-B1- 8 139 670
- WAMBACQ, P. ET AL.: 'A single-package solution for wireless transceivers.' DESIGN, AUTOMATION AND TEST IN EUROPE CONFERENCE AND EXHIBITION 31 December 1999, pages 425 - 429, XP010329413 Retrieved from the Internet: <URL:http://peace.snu.ac.kr/private/Date200 4/papers/1999/date99/pdffiles/06c_3.pdf>
- STMICROELECTRONICS: 'STLC4420 dual-band IEEE 802. 11a/b/g Wi-Fi solution' IEEE 802. 11A/B/G WI-FI SOLUTION [DATA SHEET] 28 February 2006, XP055365000 Retrieved from the Internet: <URL:http://www.anglia.com/st/literature_pd fs/fldua10206.pdf>
- MOGHE, S ET AL.: 'Design considerations for multimode multiband WLANs.' MICROWAVE JOURNAL vol. 45, no. 9, 01 September 2002, pages 132 - 150., XP008184140 Retrieved from the Internet: <URL:http://www.microwavejournal.com/articl es/print/5575-design-considerations-for-mul timode-multiband-wlans>

## Description

### FIELD OF THE INVENTION

The present invention relates generally to wireless communication, and particularly to methods and systems for concurrent dual band operation in a Wireless Local Area Network (WLAN) device.

### BACKGROUND OF THE INVENTION

A Wireless Local-Area Network (WLAN) typically comprises one or more Access Points (APs) that communicate with stations (STAs). WLAN communication protocols are specified, for example, in the IEEE 802.11 family of standards, such as in the 802.11n-2009 standard entitled "IEEE Standard for Information technology - Local and metropolitan area networks - Specific requirements - Part 11: Wireless LAN Medium Access Control (MAC) and Physical Layer (PHY) Specifications Amendment 5: Enhancements for Higher Throughput," 2009; and in the 802.11ac-2013 standard entitled "IEEE Standard for Information technology - Local and metropolitan area networks - Specific requirements - Part 11: Wireless LAN Medium Access Control (MAC) and Physical Layer (PHY) Specifications Amendment 4: Enhancements for Very High Throughput for Operation in Bands below 6 GHz," 2013. WLANs are also commonly referred to as Wi-Fi networks.

US-A-2012/250,666 discloses a dual band wireless local area network transceiver. There is disclosed a wireless communication device including at least two different transceivers (or radios) to affectuate communications with other wireless communication devices using at least two respective frequency bands. Each of the two transceivers may have different respective circuitry. Coordination is made regarding when certain component of one transceiver turn and operate when another transceiver may be transmitting or receiving communications.

US-A-2001/038,282 discloses a wireless transmission system including a plurality of systems of millimetre wave signal transmission lines capable of individually transmitting information in a millimetre wave band independently of each other. A sending section disposed on one end side of each of the plural systems of millimetre wave signal transmission lines is provided and a reception section disposed on the other end side of each of the plural systems of millimetre wave signal transmission lines.

### SUMMARY OF THE INVENTION

The invention is defined by the appended independent claims. Preferred embodiments are specified by the dependent claims.

According to a first aspect of the present invention, there is provided a wireless Local Area Network (WLAN) device, comprising: a first transceiver, which is configured to communicate on a first frequency band, and which comprises a first Multi-Chip Module (MCM) comprising a first Radio-Frequency Integrated Circuit (RFIC) for transmitting and receiving on the first frequency band and a first BaseBand Integrated Circuit (BBIC); and a second transceiver, which is configured to communicate on a second frequency band, and which comprises a second MCM comprising a second RFIC for transmitting and receiving on the second frequency band and a second BBIC that is identical to the first BBIC, wherein the first and second RFICs and the first and second BBICs comprise bond pads to provide interfaces, wherein the first RFIC is connected to the first BBIC and the second RFIC is connected to the second BBIC using direct bond wires between the bond pads, and wherein the bond pads of each of the first and second RFICs and the first and second BBICs are positioned such that no two of the direct bond wires cross over one another, wherein the first RFIC comprises a basic configuration set of transceiver chains, and wherein the second RFIC comprises a basic configuration set of transceiver chains that correspond respectively to the basic configuration set of transceiver chains of the first RFIC, plus one or more additional transceiver chains, and wherein the interfaces of the transceiver chains in the second RFIC are ordered in the same order as corresponding interfaces of the transceiver chains in the first RFIC, and wherein the one or more additional transceiver chains of the second RFIC are laid on one or more edges of a contiguous block comprising the basic configuration set of transceiver chains.

According to a second aspect of the present invention, there is provided a method, comprising: by a Wireless Local Area Network (WLAN) device, communicating on a first frequency band, using a first Multi-Chip Module (MCM) comprising a first Radio-Frequency Integrated Circuit (RFIC) for transmitting and receiving on the first frequency band and a first BaseBand Integrated Circuit (BBIC); and concurrently communicating on a second frequency band, using a second MCM comprising a second RFIC for transmitting and receiving on the second frequency band and a second BBIC that is identical to the first BBIC, wherein the first and second RFICs and the first and second BBICs comprise bond pads to provide interfaces, wherein the first RFIC is connected to the first BBIC and the second RFIC is connected to the second BBIC using direct bond wires between the bond pads, and wherein the bond pads of each of the first and second RFICs and the first and second BBICs are positioned such that no two of the direct bond wires cross over one another, wherein the first RFIC comprises a basic configuration set of transceiver chains, and wherein the second RFIC comprises a basic configuration set of transceiver chains that correspond respectively to the basic configuration set of transceiver chains of the first RFIC, plus one or more additional transceiver chains, and wherein the interfaces of the transceiver chains in the second RFIC are ordered in the same order as corresponding interfaces of the first transceiver chains in the first RFIC, and wherein the additional transceiver chains are laid on one or more edges of a contiguous block comprising the basic configuration set of the transceiver chains.

According to a third aspect of the present invention, there is provided a method, comprising: producing a first transceiver, which comprises a first Multi-Chip Module (MCM) comprising a first Radio-Frequency Integrated Circuit (RFIC) for transmitting and receiving on a first frequency band and a first BaseBand Integrated Circuit (BBIC); producing a second transceiver, which comprises a second MCM comprising a second RFIC for transmitting and receiving on a second frequency band and a second BBIC that is identical to the first BBIC; and integrating the first and second transceivers to produce a concurrent, dual-band communication device, wherein the first and second RFICs and the first and second BBICs comprise bond pads to provide interfaces for connecting the first RFIC to the first BBIC and the second RFIC to the second BBIC using direct bond wires between the bond pads, wherein the bond pads of each of the first and second RFICs and the first and second BBICs are positioned such that no two of the direct bond wires cross over one another, wherein the first RFIC comprises a basic configuration set of transceiver chains, and wherein the second RFIC comprises a basic configuration set of transceiver chains that correspond respectively to the a basic configuration set of transceiver chains of the first RFIC, plus one or more additional transceiver chains, and wherein the transceiver chains in the second RFIC are laid adjacent to one another in a contiguous block and ordered in the same order as the basic configuration set of transceiver chains in the first RFIC, and wherein the additional transceiver chains are laid on one or more edges of the contiguous block.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a WLAN device, in accordance with an embodiment of the present invention;
Fig. 2 is a diagram that schematically illustrates a Multi-Chip Module (MCM) package of a WLAN device, in accordance with an embodiment of the present invention; and
Figs. 3A and 3B are diagrams that schematically illustrate two Radio Frequency Integrated Circuits (RFICs) of a WLAN device, in accordance with an embodiment of the present invention.

### DETAILED DESCRIPTION OF EMBODIMENTS

### OVERVIEW

Embodiments of the present invention that are described herein provide improved methods and systems for Wireless Local Area Network (WLAN) communication. In the disclosed embodiments, a concurrent dual band WLAN device comprises two transceivers. Each transceiver is configured to communicate in a different frequency band, denoted a first band or a second band. In addition each transceiver comprises a Multi-Chip Module (MCM), and a corresponding Radio Frequency (RF) front end (RFFE) which is adapted to the frequency band of the respective MCM.

Each MCM comprises an RF Integrated Circuit (RFIC), which comprises one or more transmit/receive (TX/RX) Radio Frequency (RF) communication chains, and a Baseband Integrated Circuit (BBIC), which performs baseband processing of transmitted and received signals. In some embodiments, the BBIC in the MCM of the first band has a common design and functionality to the BBIC in the MCM of the second band.

Bond pads may act as a physical interface to a chip, for connecting between chips in the MCM. In some embodiments, the RFIC of the first frequency band has a different number of RF chains than the RFIC of the second frequency band, and thus, a different number of interface bond pads. The pads on the BBIC are configured so that either the first or the second RFIC may be connected to the BBIC using direct bond wires. The BBIC and RFIC pads are configured so that no matter which RFIC is connected to the BBIC, there are no crossed bond wires between the RFIC and the BBIC. Typically, each transceiver chain is located in the first RFIC and in the second RFIC, opposite its corresponding circuitry in the BBIC.

Using substantially similar BBICs, and a configuration of bond pads as described above, simplifies and enhances the flexibility of the design and manufacturing processes of WLAN devices operating in concurrent multiple frequency bands.

### SYSTEM DESCRIPTION

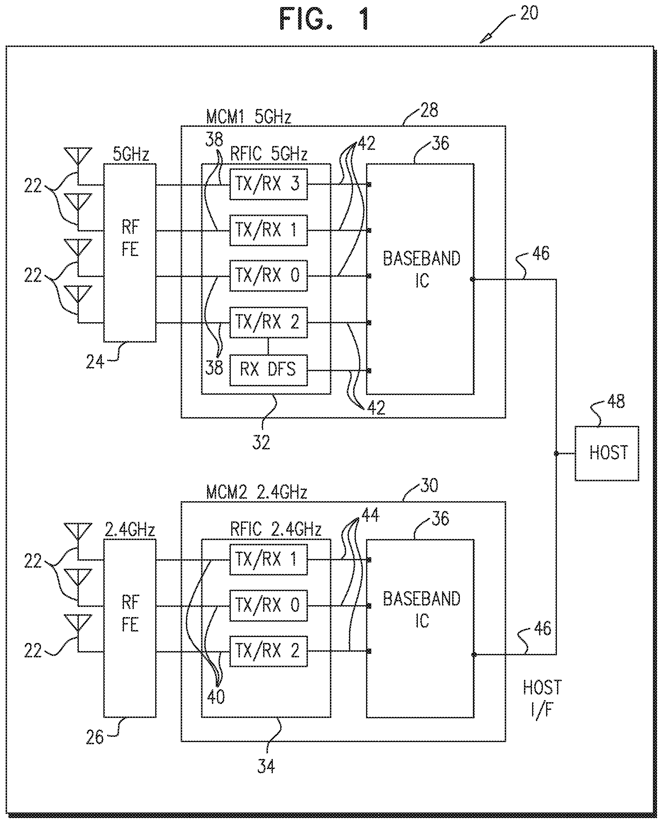

Fig. 1 is a block diagram that schematically illustrates a WLAN device 20, in accordance with an embodiment of the present invention. Device 20 may operate as a WLAN Access Point (AP) or as a WLAN station (STA). Device 20 is configured to communicate with remote WLAN devices in accordance with WLAN standards such as the IEEE 802.11 standards, cited above.

In the present example, device 20 is capable of concurrently transmitting and receiving two frequency bands of WLAN signals, so is also referred to herein as dual-band device 20. Herein, by way of example, the two frequency bands are assumed to be at 2.4GHz and 5GHz. Dual-band device 20 comprises a host 48, which is connected via a host interface (I/F) 46 to two Multi-Chip Modules (MCMs). Each MCM operates in one of the two frequency bands. A 5GHz MCM 28 comprises a BaseBand integrated circuit (BBIC) 36, which is connected via wires 42 to a Radio-Frequency Integrated Circuit (RFIC) 32. BBIC 36 processes signals conveyed to and from RFIC 32, and RFIC 32 transmits and receives signals via four antennas 22.

RFIC 32 comprises four transmit/receive (TX/RX) chains, denoted TX/RX 0 - TX/RX 3, which use respective antennas 22. RFIC 32 also has a Dynamic Frequency Selection (DFS) auxiliary receive chain, which comprises a receiver (RX) and which is connected to TX/RX 2 in RFIC 32.

In the 5GHz frequency band, regulatory requirements, such as are in the IEEE 802.11 family of standards, specify that WLAN device 20 must detect the presence of radar signals and, if detected, switch, when applicable, to a different channel. The DFS auxiliary receive chain is typically used for analyzing signal activity on alternative communication channels. The signal activity evaluation can be used, for example, for identifying alternative channels that device 20 may later choose to switch to, or for collecting statistical activity data. (Throughout the present patent application, the terms "channels," "frequency channels" and "communication channels" are used interchangeably). In the example of Fig. 1, the auxiliary chain shares the antenna and some of the reception hardware of TX/RX2.

Further aspects of WLAN devices having an auxiliary chain are addressed, for example, in U.S. Patent Application 14/278,117, filed May 15, 2014.

In some embodiments, the four transmit/receive (TX/RX) chains in MCM 28 are coupled, via wires 38, to four respective front-ends located on an RF front-end (RFFE) 24 communication device. The four front-ends are connected to four respective antennas 22.

Device 20 also comprises a 2.4GHz MCM 30, which comprises an identical BBIC 36 to the BBIC in MCM 28. In MCM 30 BBIC 36 is connected by wires 44 to an RFIC 34, which is contained in MCM 30 as well.

In the present example, RFIC 34 comprises three transmit/receive (TX/RX) chains, denoted TX/RX 0 - TX/RX 2, which (aside from the difference in frequency band) perform similar functions to the respective TX/RX 0 - TX/RX 2 in RFIC 32, and located in the same position on the RFIC chip. The three transmit/receive (TX/RX) chains in MCM 30 are coupled, via wires 38, to three respective front-ends (FEs) of the chains, located on RFFE 26, which are connected to three respective antennas 22.

In some embodiments, BBIC 36 devices in MCMs 28 and 30 have a common design, structure and functionality, regardless of the frequency bands in use, while RFICs 32 and 34 have different structure and functionality, according to the respective frequency band of each RFIC.

In each TX/RX chain, the transmit path begins in BBIC 36, which generates a digital BaseBand signal for transmission. The signal is transmitted, via a TX/RX chain and RFFE 24 or RFFE 26, to a respective antenna 22.

In the receive path of each TX/RX chain, antenna 22 receives an analog RF signal. In MCM 28 RFFE 24 switches the signal to a given TX/RX chain in RFIC 32. The chain converts the signal to a digital format, and transmits the digital signal to BBIC 36. MCM 30 has a similar receive path to that of MCM 28.

The configuration of WLAN device 20 shown in Fig. 1 is an example configuration, which is chosen purely for the sake of conceptual clarity. In alternative embodiments, any other suitable device configuration can be used. For example, device 20 may comprise any suitable number of TX/RX chains in either frequency band, or even a single chain. As another example, in Fig. 1 the 5GHz MCM comprises a DFS auxiliary receive chain, whereas the 2.4GHz MCM does not. Generally, however, either MCM may or may not comprise a DFS RX chain.

Alternatively, the functionality of the front-ends may be implemented in the RFIC. In another configuration, device 20 may be implemented without an RFIC.

The different elements of device 20 may be implemented using suitable hardware, such as Application-Specific Integrated Circuits (ASICs) or Field-Programmable Gate Arrays (FPGAs). In some embodiments, some elements of device 20, e.g., BBIC 36, can be implemented using software, or using a combination of hardware and software elements. Elements of device 20 that are not mandatory for understanding of the disclosed techniques have been omitted from the figure for the sake of clarity.

In some embodiments, some or all of BBIC 36 and some or all of host 48 may comprise a general-purpose processor, which is programmed in software to carry out the functions described herein. The software may be downloaded to the processor in electronic form, over a network, for example, or it may, alternatively or additionally, be provided and/or stored on non-transitory tangible media, such as magnetic, optical, or electronic memory. This processor may be internal or external to the BBIC.

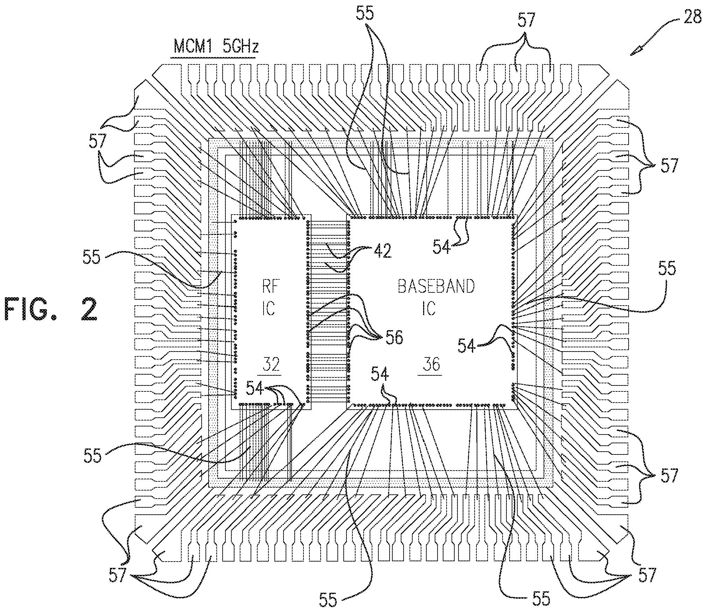

Fig. 2 is a diagram that schematically illustrates Multi-Chip Module (MCM) 28 of WLAN device 20, in accordance with an embodiment of the present invention.

MCM 28 comprises BBIC 36 and RFIC 32. Each IC comprises bond pads 54, which connect the IC, via wires 55, to pins 57 located in the periphery of the MCM package. Furthermore, each IC comprises pads 56, which connect BBIC 36 and RFIC 32 to each other, by direct bond wires 42.

In some embodiments, the structure of MCM 28, which operates at 5GHz frequency, corresponds to that for MCM 30, which operates at 2.4 GHz. This correspondence helps to simplify the design and manufacturing processes of similar WLAN devices, including devices using other frequency bands.

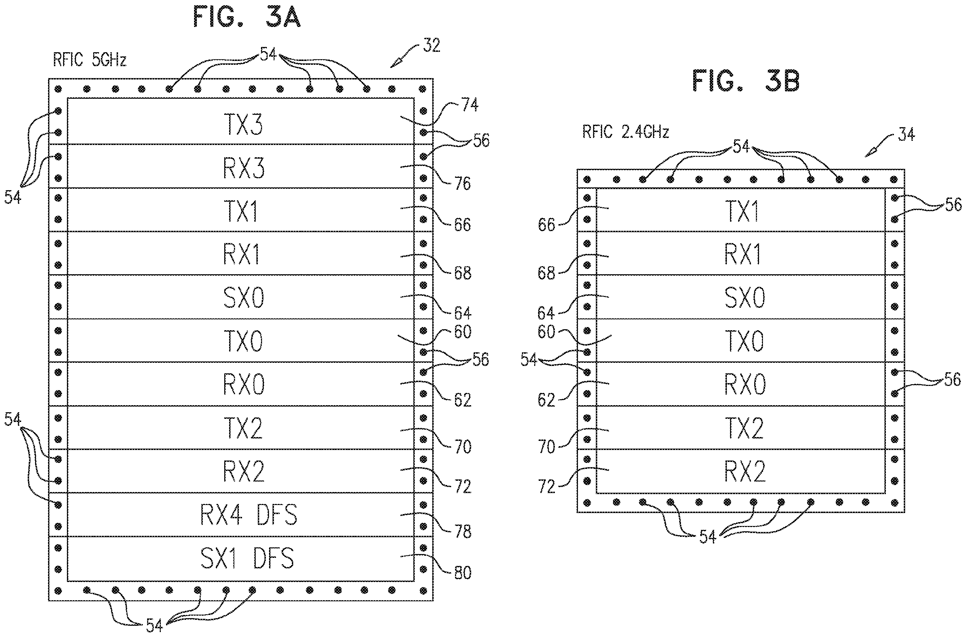

Fig. 3A is a diagram that schematically illustrates the structure of RFIC 32 which is configured to operate at a 5GHz frequency, in accordance with an embodiment of the present invention.

In this example, RFIC 32 comprises eleven (11) modules. Each module represents a transmit chain, or a receive chain, or a frequency source of the chains. The various modules are also referred to as transceiver sections.

Modules TX0, TX1, TX2, and TX3, are transmit chains, denoted 60, 66, 70, and 74 respectively. The respective receive chains; RX0, RX1, RX2, and RX3, are denoted 62, 68, 72, and 76 respectively.

RX4 DFS 78 is a DFS auxiliary receive chain, which shares the antenna of TX/RX2 in Fig. 1. SX0 64 is a frequency source for TX/RX0 - TX/RX3 chains, and SX1 DFS 80 is a frequency source for RX4 DFS 78.

SX0 64 and SX1 DFS 80 are configured to generate Local Oscillator (LO) signals for TX/RX0 - TX/RX3, and for RX4 DFS 78, respectively.

Fig. 3B is a diagram that schematically illustrates the structure of RFIC 34, which is configured to operate at a 2.4GHz frequency, in accordance with an embodiment of the present invention.

RFIC 34 comprises seven (7) modules of transmit/receive chains TX/RX0 - TX/RX2. Each module represents a transmit chain, or a receive chain, or a frequency source of the chains.

In some embodiments, the on-chip location of corresponding chains and frequency sources (in this case, the TX/RX0 - TX/RX2 chains and the SX0 DFS frequency source), and their respective bond pads 54 and 56, are identical for RFICs 32 and 34. As can be seen from comparing Figs. 3A and 3B, the modules [TX1,RX1,SX0,TX0,RX0,TX2,RX2] are arranged in the same order on RFIC 32 and on RFIC 34. This design commonality enables interchangeability between RFICs 32 and 34 and their respective MCMs 28 and 30. As a result, MCMs 28 and 30 can use an identical BBIC 36, as shown in Fig. 1. In particular, both RFIC 32 and RFIC 34 can be bonded to BBIC 36 using direct bond wires that do not cross over one another.

### COMMONALITY IN MCM STRUCTURES OF CONCURRENT MULTIPLE BAND WLAN DEVICES

In some embodiments, using a common structure and interface of the TX/RX chains at the RFICs, allows formation of multiple-band devices using the same BBIC and similar wiring and packaging schemes in the corresponding MCMs.

The number of RF chains is application specific. In the example of device 20, regulatory requirements for 5 GHz frequency band (e.g., IEEE 802.11 family of standards) specify that WLAN device 20 must detect the presence of radar signals. Accordingly, device 20 can comprise a DFS auxiliary receive chain in RFIC 32. Furthermore, the RFIC may comprise additional transceiver chains, such as TX/RX3 chains. Thus, in the present example, RFIC 32 comprises 11 modules, while RFIC 34 comprises 7 modules.

In some embodiments, there is a different number of transceiver chains in RFIC 32 compared to RFIC 34. However, the common transceiver chains in both RFICs, are lined up identically facing their corresponding circuitry in the BBIC. Thus, RFICs 32 and 34 are interchangeable with each other in relation to the interface with BBIC.

In other embodiments, bond pads 54 and 56 of the RFICs and the BBIC, are configured to avoid crossing wires between the RFIC and the BBIC, in case of switching RFIC 32 with RFIC 34, and *vice versa.*

In yet other embodiments, RFIC 32 comprises a basic configuration set of transceiver chains (e.g., TX/RX 0 - TX/RX 2), which is identical to the configuration of the same set of transceiver chain of RFIC 34. In addition, RFIC 32 comprises one or more additional transceiver sets (or sections), such as TX/RX 3 and/or the RX auxiliary chain, as shown in Fig. 1. The additional transceiver sets (sections) are laid on one or more edges of a contiguous block comprising the basic configuration set of transceiver chains (denoted TX/RX 0 - TX/RX 2).

In an embodiment, the layout of the various chains in the RFIC floor plans are not restricted to the configuration illustrated in Figs. 3A and 3B. The important feature is that the interfaces between the RFIC and the BBIC (pads 56) should be configured at the RFICs and the BBICs as described in Figs. 3A and 3B, to avoid crossing wires between the RFIC and the BBIC.

In another embodiment, the pads configuration in RFIC 34 are a subset of the pads in RFIC 32. As described above, both RFICs comprise three TX/RX chains (TX/RX 0 - TX/RX 2), and their respective pads are at identical locations in the RFIC. RFIC 32 comprises additional groups of pads and the DFS groups, which are not present in RFIC 34.

The configuration presented in Figs. 3A-3B is an example. In alternative embodiments, any other suitable configuration may be used for the same frequency bands as well as for different frequencies.

It will be appreciated that the embodiments described above are cited by way of example, and that the present invention is not limited to what has been particularly shown and described hereinabove. Rather, the scope of the present invention is defined by the appended claims.

## Claims

1. A wireless Local Area Network (WLAN) device (20), comprising:
a first transceiver (28), which is configured to communicate on a first frequency band, and which comprises a first Multi-Chip Module (MCM) comprising a first Radio-Frequency Integrated Circuit (RFIC) (32) for transmitting and receiving on the first frequency band and a first BaseBand Integrated Circuit (BBIC); and
a second transceiver (30), which is configured to communicate on a second frequency band, and which comprises a second MCM comprising a second RFIC (34) for transmitting and receiving on the second frequency band and a second BBIC that is identical to the first BBIC,
wherein the first and second RFICs and the first and second BBICs (36) comprise bond pads (54, 56) to provide interfaces, wherein the first RFIC is connected to the first BBIC and the second RFIC is connected to the second BBIC using direct bond wires between the bond pads (54, 56), and wherein the bond pads of each of the first and second RFICs and the first and second BBICs are positioned such that no two of the direct bond wires cross over one another,
wherein the first RFIC comprises a basic configuration set of transceiver chains, and wherein the second RFIC comprises a basic configuration set of transceiver chains that correspond respectively to the basic configuration set of transceiver chains of the first RFIC, plus one or more additional transceiver chains,
and wherein the interfaces of the transceiver chains in the second RFIC are ordered in the same order as corresponding interfaces of the transceiver chains in the first RFIC, and wherein the one or more additional transceiver chains of the second RFIC are laid on one or more edges of a contiguous block comprising the basic configuration set of transceiver chains.

2. The WLAN device according to claim 1, wherein the interfaces of the transceiver chains in the first and second RFICs are configured to face respective baseband circuits in the first and second BBICs, respectively.

3. A method, comprising:
by a Wireless Local Area Network (WLAN) device, communicating on a first frequency band, using a first Multi-Chip Module (MCM) comprising a first Radio-Frequency Integrated Circuit (RFIC) (32) for transmitting and receiving on the first frequency band and a first BaseBand Integrated Circuit (BBIC); and
concurrently communicating on a second frequency band, using a second MCM comprising a second RFIC (34) for transmitting and receiving on the second frequency band and a second BBIC that is identical to the first BBIC,
wherein the first and second RFICs and the first and second BBICs (36) comprise bond pads to provide interfaces, wherein the first RFIC is connected to the first BBIC and the second RFIC is connected to the second BBIC using direct bond wires between the bond pads (54, 56), and wherein the bond pads of each of the first and second RFICs and the first and second BBICs are positioned such that no two of the direct bond wires cross over one another,
wherein the first RFIC comprises a basic configuration set of transceiver chains, and wherein the second RFIC comprises a basic configuration set of transceiver chains that correspond respectively to the basic configuration set of transceiver chains of the first RFIC, plus one or more additional transceiver chains,
and wherein the interfaces of the transceiver chains in the second RFIC are ordered in the same order as corresponding interfaces of the first transceiver chains in the first RFIC, and wherein the additional transceiver chains are laid on one or more edges of a contiguous block comprising the basic configuration set of the transceiver chains.

4. The method according to claim 3, wherein the interfaces of the transceiver chains in the first and second RFICs are configured to face respective baseband circuits in the first and second BBICs, respectively.

5. A method, comprising:
producing a first transceiver, which comprises a first Multi-Chip Module (MCM) comprising a first Radio-Frequency Integrated Circuit (RFIC) for transmitting and receiving on a first frequency band and a first BaseBand Integrated Circuit (BBIC);
producing a second transceiver, which comprises a second MCM comprising a second RFIC for transmitting and receiving on a second frequency band and a second BBIC that is identical to the first BBIC; and
integrating the first and second transceivers to produce a concurrent, dual-band communication device,
wherein the first and second RFICs and the first and second BBICs comprise bond pads to provide interfaces for connecting the first RFIC to the first BBIC and the second RFIC to the second BBIC using direct bond wires between the bond pads, wherein the bond pads of each of the first and second RFICs and the first and second BBICs are positioned such that no two of the direct bond wires cross over one another,
wherein the first RFIC comprises a basic configuration set of transceiver chains, and wherein the second RFIC comprises a basic configuration set of transceiver chains that correspond respectively to the a basic configuration set of transceiver chains of the first RFIC, plus one or more additional transceiver chains,
and wherein the transceiver chains in the second RFIC are laid adjacent to one another in a contiguous block and ordered in the same order as the basic configuration set of transceiver chains in the first RFIC, and wherein the additional transceiver chains are laid on one or more edges of the contiguous block.

6. The method according to claim 5, wherein the interfaces of the transceiver chains in the first and second RFICs are configured to face respective baseband circuits in the first and second BBICs, respectively.

## Patentansprüche

1. Vorrichtung für drahtlose lokale Netzwerke (WLAN) (20), umfassend:
einen ersten Sende-Empfänger (28), der ausgelegt ist, auf einem ersten Frequenzband zu kommunizieren, und der ein erstes Mehrchipmodul (MCM) umfasst, das einen ersten integrierten Funkfrequenzschaltkreis (RFIC) (32) zum Senden und Empfangen auf dem ersten Frequenzband und einen ersten integrierten Basisbandschaltkreis (BBIC) umfasst; und
einen zweiten Sende-Empfänger (30), der ausgelegt ist, auf einem zweiten Frequenzband zu kommunizieren, und der ein zweites MCM umfasst, das einen zweiten RFIC (34) zum Senden und Empfangen auf dem zweiten Frequenzband und einen zweiten BBIC umfasst, der mit dem ersten BBIC identisch ist,
wobei der erste und der zweite RFIC und der erste und der zweite BBIC (36) Bondinseln (54, 56) umfassen, um Schnittstellen bereitzustellen, wobei der erste RFIC mit dem ersten BBIC verbunden ist und der zweite RFIC mit dem zweiten BBIC verbunden ist, unter Verwendung von direkten Bonddrähten zwischen den Bondinseln (54, 56), und wobei die Bondinseln jedes des ersten und des zweiten RFICs und des ersten und des zweiten BBICs so positioniert sind, dass keine zwei der direkten Bonddrähte übereinander kreuzen,
wobei der erste RFIC einen grundlegenden Konfigurationssatz von Sende-Empfänger-Ketten umfasst und wobei der zweite RFIC einen grundlegenden Konfigurationssatz von Sende-Empfänger-Ketten umfasst, der jeweils dem grundlegenden Konfigurationssatz von Sende-Empfänger-Ketten des ersten RFIC sowie einer oder mehreren zusätzlichen Sende-Empfänger-Ketten entspricht,
und wobei die Schnittstellen der Sende-Empfänger-Ketten im zweiten RFIC in der gleichen Reihenfolge wie entsprechende Schnittstellen der Sende-Empfänger-Ketten im ersten RFIC gereiht sind, und wobei die eine oder die mehreren zusätzlichen Sende-Empfänger-Ketten des zweiten RFIC an einer oder mehreren Kanten eines zusammenhängenden Blocks verlegt sind, der den grundlegenden Konfigurationssatz der Sende-Empfänger-Ketten bildet.

2. WLAN-Vorrichtung nach Anspruch 1, wobei die Schnittstellen der Sende-Empfänger-Ketten im ersten und zweiten RFIC ausgelegt sind, jeweiligen Basisbandschaltkreisen im ersten bzw. zweiten BBIC gegenüberzuliegen.

3. Verfahren, umfassend:
durch eine drahtlose lokale Netzwerk-Vorrichtung (WLAN-Vorrichtung), die auf einem ersten Frequenzband unter Verwendung eines ersten Mehrchipmoduls (MCM) kommuniziert,
das einen ersten integrierten Funkfrequenzschaltkreis (RFIC) (32) zum Senden und Empfangen auf dem ersten Frequenzband und einen ersten integrierten Basisbandschaltkreis (BBIC) umfasst; und
gleichzeitig auf einem zweiten Frequenzband unter Verwendung eines zweiten MCM kommuniziert, das einen zweiten RFIC (34) zum Senden und Empfangen auf dem zweiten Frequenzband und
einen zweiten BBIC umfasst, der mit dem ersten BBIC identisch ist,
wobei der erste und der zweite RFIC und der erste und der zweite BBIC (36) Bondinseln umfassen, um Schnittstellen bereitzustellen, wobei der erste RFIC mit dem ersten BBIC verbunden ist und der zweite RFIC mit dem zweiten BBIC verbunden ist, unter Verwendung von direkten Bonddrähten zwischen den Bondinseln (54, 56), und wobei die Bondinseln jedes des ersten und des zweiten RFICs und des ersten und des zweiten BBICs so positioniert sind, dass keine zwei der direkten Bonddrähte übereinander kreuzen,
wobei der erste RFIC einen grundlegenden Konfigurationssatz von Sende-Empfänger-Ketten umfasst und wobei der zweite RFIC einen grundlegenden Konfigurationssatz von Sende-Empfänger-Ketten umfasst, der jeweils dem grundlegenden Konfigurationssatz von Sende-Empfänger-Ketten des ersten RFIC sowie einer oder mehreren zusätzlichen Sende-Empfänger-Ketten entspricht,
und wobei die Schnittstellen der Sende-Empfänger-Ketten im zweiten RFIC in der gleichen Reihenfolge wie entsprechende Schnittstellen der ersten Sende-Empfänger-Ketten im ersten RFIC gereiht sind, und wobei die zusätzlichen Sende-Empfänger-Ketten an einer oder mehreren Kanten eines zusammenhängenden Blocks verlegt sind, der den grundlegenden Konfigurationssatz der Sende-Empfänger-Ketten bildet.

4. Verfahren nach Anspruch 3, wobei die Schnittstellen der Sende-Empfänger-Ketten im ersten und zweiten RFICs ausgelegt sind, jeweiligen Basisbandschaltkreisen im ersten bzw. zweiten BBIC gegenüberzuliegen.

5. Verfahren, umfassend:
Erzeugen eines ersten Sende-Empfängers, der ein erstes Mehrchipmodul (MCM) umfasst, das einen ersten integrierten Funkfrequenzschaltkreis (RFIC) zum Senden und Empfangen auf einem ersten Frequenzband und einen ersten integrierten Basisbandschaltkreis (BBIC) umfasst;
Erzeugen eines zweiten Sende-Empfängers, der ein zweites MCM umfasst, das einen zweiten RFIC zum Senden und Empfangen auf einem zweiten Frequenzband und einen zweiten BBIC umfasst, der mit dem ersten BBIC identisch ist; und
Integrieren des ersten und des zweiten Sende-Empfängers, um eine gleichzeitige Zweiband-Kommunikationsvorrichtung zu erzeugen,
wobei der erste und der zweite RFIC und der erste und der zweite BBIC Bondinseln umfassen, um Schnittstellen bereitzustellen, um den ersten RFIC mit dem ersten BBIC zu verbinden und den zweiten RFIC mit dem zweiten BBIC zu verbinden, unter Verwendung von direkten Bonddrähten zwischen den Bondinseln, wobei die Bondinseln jedes des ersten und des zweiten RFICs und des ersten und des zweiten BBICs so positioniert sind, dass keine zwei der direkten Bonddrähte übereinander kreuzen,
wobei der erste RFIC einen grundlegenden Konfigurationssatz von Sende-Empfänger-Ketten umfasst und wobei der zweite RFIC einen grundlegenden Konfigurationssatz von Sende-Empfänger-Ketten umfasst, der jeweils dem grundlegenden Konfigurationssatz von Sende-Empfänger-Ketten des ersten RFIC sowie einer oder mehreren zusätzlichen Sende-Empfänger-Ketten entspricht,
und wobei die Sende-Empfänger-Ketten im zweiten RFIC nebeneinander in einem zusammenhängenden Block verlegt und in der gleichen Reihenfolge wie der grundlegende Konfigurationssatz der Sende-Empfänger-Ketten im ersten RFIC gereiht sind, und wobei die zusätzlichen Sende-Empfänger-Ketten an einer oder mehreren Kanten des zusammenhängenden Blocks verlegt sind.

6. Verfahren nach Anspruch 5, wobei die Schnittstellen der Sende-Empfänger-Ketten im ersten und zweiten RFICs ausgelegt sind, jeweiligen Basisbandschaltkreisen im ersten bzw. zweiten BBIC gegenüberzuliegen.

## Revendications

1. Dispositif de réseau local sans fil (WLAN) (20), comprenant :
un premier émetteur-récepteur (28), qui est configuré pour communiquer sur une première bande de fréquences, et qui comprend un premier module multi-puce (MCM) comprenant un premier circuit intégré radiofréquence (RFIC) (32) pour émettre et recevoir sur la première bande de fréquences et un premier circuit intégré en bande de base (BBIC) ; et
un second émetteur-récepteur (30), qui est configuré pour communiquer sur une seconde bande de fréquences, et qui comprend un second MCM comprenant un second RFIC (34) pour émettre et recevoir sur la seconde bande de fréquences et un second BBIC qui est identique au premier BBIC,
dans lequel les premier et second RFIC et les premier et second BBIC (36) comprennent des aires de soudure (54, 56) pour fournir des interfaces, le premier RFIC étant connecté au premier BBIC et le second RFIC étant connecté au second BBIC à l'aide de fils de connexion directs entre les aires de soudure (54, 56), et les aires de soudure de chacun des premier et second RFIC et des premier et second BBIC étant positionnées de telle sorte que deux fils de connexion directs quelconques parmi les fils de connexion directs ne se croisent pas l'un l'autre,
dans lequel le premier RFIC comprend un ensemble de configuration de base de chaînes d'émetteurs-récepteurs, et dans lequel le second RFIC comprend un ensemble de configuration de base de chaînes d'émetteurs-récepteurs qui correspondent respectivement à l'ensemble de configuration de base de chaînes d'émetteurs-récepteurs du premier RFIC, plus une ou plusieurs chaînes d'émetteurs-récepteurs supplémentaires,
et dans lequel les interfaces des chaînes d'émetteurs-récepteurs dans le second RFIC sont ordonnées dans le même ordre que des interfaces correspondantes des chaînes d'émetteurs-récepteurs dans le premier RFIC, et dans lequel la ou les chaînes d'émetteurs-récepteurs supplémentaires du second RFIC sont disposées sur un ou plusieurs bords d'un bloc contigu comprenant l'ensemble de configuration de base de chaînes d'émetteurs-récepteurs.

2. Dispositif WLAN selon la revendication 1, dans lequel les interfaces des chaînes d'émetteurs-récepteurs dans les premier et second RFIC sont configurées pour faire face à des circuits en bande de base respectifs dans les premier et second BBIC, respectivement.

3. Procédé, comprenant :
par un dispositif de réseau local sans fil (WLAN), communiquer sur une première bande de fréquences, à l'aide d'un premier module multi-puce (MCM) comprenant un premier circuit intégré radiofréquence (RFIC) (32) pour émettre et recevoir sur la première bande de fréquences et un premier circuit intégré en bande de base (BBIC) ; et
communiquer simultanément sur une seconde bande de fréquences, à l'aide d'un second MCM comprenant un second RFIC (34) pour émettre et recevoir sur la seconde bande de fréquences et un second BBIC qui est identique au premier BBIC,
dans lequel les premier et second RFIC et les premier et second BBIC (36) comprennent des aires de soudure pour fournir des interfaces, le premier RFIC étant connecté au premier BBIC et le second RFIC étant connecté au second BBIC à l'aide de fils de connexion directs entre les aires de soudure (54, 56), et les aires de soudure de chacun des premier et second RFIC et des premier et second BBIC étant positionnées de telle sorte que deux fils de connexion directs quelconques parmi les fils de connexion directs ne se croisent pas l'un l'autre,
dans lequel le premier RFIC comprend un ensemble de configuration de base de chaînes d'émetteurs-récepteurs, et dans lequel le second RFIC comprend un ensemble de configuration de base de chaînes d'émetteurs-récepteurs qui correspondent respectivement à l'ensemble de configuration de base de chaînes d'émetteurs-récepteurs du premier RFIC, plus une ou plusieurs chaînes d'émetteurs-récepteurs supplémentaires,
et dans lequel les interfaces des chaînes d'émetteurs-récepteurs dans le second RFIC sont ordonnées dans le même ordre que des interfaces correspondantes des premières chaînes d'émetteurs-récepteurs dans le premier RFIC, et dans lequel les chaînes d'émetteurs-récepteurs supplémentaires sont disposées sur un ou plusieurs bords d'un bloc contigu comprenant l'ensemble de configuration de base des chaînes d'émetteurs-récepteurs.

4. Procédé selon la revendication 3, dans lequel les interfaces des chaînes d'émetteurs-récepteurs dans les premier et second RFIC sont configurées pour faire face à des circuits en bande de base respectifs dans les premier et second BBIC, respectivement.

5. Procédé, comprenant :
produire un premier émetteur-récepteur, qui comprend un premier module multi-puce (MCM) comprenant un premier circuit intégré radiofréquence (RFIC) pour émettre et recevoir sur une première bande de fréquences et un premier circuit intégré en bande de base (BBIC) ;
produire un second émetteur-récepteur, qui comprend un second MCM comprenant un second RFIC pour émettre et recevoir sur une seconde bande de fréquences et un second BBIC qui est identique au premier BBIC ; et
intégrer les premier et second émetteurs-récepteurs pour produire un dispositif de communication à double bande, simultanée,
dans lequel les premier et second RFIC et les premier et second BBIC comprennent des aires de soudure pour fournir des interfaces pour relier le premier RFIC au premier BBIC et le second RFIC au second BBIC à l'aide de fils de connexion directs entre les aires de soudure, les aires de soudure de chacun des premier et second RFIC et des premier et second BBIC étant positionnées de telle sorte que deux fils de connexion directs quelconques parmi les fils de connexion directs ne se croisent pas l'un l'autre,
dans lequel le premier RFIC comprend un ensemble de configuration de base de chaînes d'émetteurs-récepteurs, et dans lequel le second RFIC comprend un ensemble de configuration de base de chaînes d'émetteurs-récepteurs qui correspondent respectivement à l'ensemble de configuration de base de chaînes d'émetteurs-récepteurs du premier RFIC, plus une ou plusieurs chaînes d'émetteurs-récepteurs supplémentaires,
et dans lequel les chaînes d'émetteurs-récepteurs dans le second RFIC sont disposées adjacentes les unes aux autres dans un bloc contigu et ordonnées dans le même ordre que l'ensemble de configuration de base de chaînes d'émetteurs-récepteurs dans le premier RFIC, et dans lequel les chaînes d'émetteurs-récepteurs supplémentaires sont disposées sur un ou plusieurs bords du bloc contigu.

6. Procédé selon la revendication 5, dans lequel les interfaces des chaînes d'émetteurs-récepteurs dans les premier et second RFIC sont configurées pour faire face à des circuits en bande de base respectifs dans les premier et second BBIC, respectivement.
